Europäisches Patentamt

European Patent Office

Office européen des brevets

(11) Veröffentlichungsnummer: **0 036 026**
**B1**

(12) **EUROPÄISCHE PATENTSCHRIFT**

(45) Veröffentlichungstag der Patentschrift: **12.11.86**

(21) Anmeldenummer: **80101196.6**

(22) Anmeldetag: **10.03.80**

(51) Int. Cl.⁴: **G 05 D 3/20**, G 01 B 11/27, H 01 L 21/68, G 05 B 19/00

(54) **Adressierbare Positioniervorrichtung.**

(43) Veröffentlichungstag der Anmeldung:
23.09.81 Patentblatt 81/38

(45) Bekanntmachung des Hinweises auf die Patenterteilung:
12.11.86 Patentblatt 86/46

(84) Benannte Vertragsstaaten:
IT

(56) Entgegenhaltungen:
DE-A-2 265 346
DE-A-2 557 675
DE-A-2 643 809
DE-A-2 707 477
DE-A-2 822 269
DE-B-1 941 057
US-A-3 898 617

(73) Patentinhaber: **EATON-OPTIMETRIX INC.**
**4001 North First Street**
**San Jose California 95134 (US)**

(72) Erfinder: **Phillips, Edward H.**
**P.O.Box 1042**
**Middletown California 95461 (US)**
Erfinder: **Johannsmeier, Karl-Heinz**
**400 Fir Lane**
**Los Altos California 94022 (US)**

(74) Vertreter: **Liesegang, Roland, Dr.-Ing.**
**Sckellstrasse 1**
**D-8000 München 80 (DE)**

Courier Press, Leamington Spa, England.

**Beschreibung**

Die Erfindung betrifft ein adressierbare Positioniervorrichtung, insbesondere zur Anwendung in einer Ausrichtvorrichtung der Bauart, die zum aufeinanderfolgenden Ausrichten von Bildern verschiedener Gebiete einer Halbleiterscheibe mit dem Muster eine Maske und zum Belichten solcher Gebiete der Halbleiterscheibe gemäß dem Muster der Maske verwendet wird, mit dem Merkmalen des Oberbegriffs des Anspruchs 1.

Bisher wurden solche in X- und Y-Richtung adressierbare Positioniervorrichtungen vorgeschlagen, bei denen eine Maske nacheinander schrittweise in unterschiedliche X- und Y-Koordinatenlagen gebracht wurde, um sequentiell unterschiedliche Teile der Maske auf das Muster einer Strichplatte zu belichten.

Ein derartiger sogenannter "Stepper" wird von der Firma Jade Manufacturing Co. hergestellt. Bei einem solchen Stepper ist die Maske auf einem Werktisch angeordnet, der adressierbar längs der X- und Y-Achse in unterschiedliche X- und Y-Koordinatenlagen beweglich ist und nacheinander so adressiert wird, daß er unterschiedliche Bereiche der Maske in Belichtungsposition gemäß dem Muster auf der Strichplatte bringt. Auf dem Werktisch sind zwei getrennte ein-dimensionale Felder aus jeweils parallelen X- und Y-Reißlinien angebracht, um den Werktisch in eine adressiert X-/Y-Koordinatenlage zu bringen, die von der Bedienungsperson gewählt wurde. Sensoren sind so engerichtet, daß sie die X- und Y-Koordinaten einer adressierten Werktischlage dadurch erfassen, daß sie nacheinander die X- und Y-Reißlinien der beiden Felder abtasten. Auf die abgetasteten X- und Y-Koordinaten sprechen X- und Y-Servomotoren an, welche den Werktisch in die von der Bedienungsperson gewählte adressierte Lage bringen. Der Werktisch kann jedoch nicht gleichzeitig in beiden Koordinatenrichtungen parallel zur X- und Y-Achse in die adressierte Position geführt werden. Vielmehr wird die Y-Koordinate der adressierten Lage zuerste erfaßt und der Werktisch zuerst längs der Y-Achse in die gewählte Y-Koordinate überführt. Sodann wird die X-Koordinate der adressierten Lage erfaßt und der Werktisch längs der X-Achse in die gewählte X-Koordinate überführt.

Dieser Stepper hat also den Nachteil, daß der Werktisch nicht auf dem kürzesten Weg von einer ersten zu einer zweiten adressierte Lage gelangen kann, sondern vielmehr aus der ersten adressierten Position zu einer Referenzposition bewegt werden muß, von der aus die X-oder Y-Reißlinien nacheinander erfaßt werden müssen, um den Werktisch in eine neue X- oder Y-Koordinate der zweiten adressierten Position zu bringen. Wenn die zweite adressierte Position sowohl eine neue X- als auch eine neue Y-Koordinate hat, muß der Werktisch zunächst in eine Referenzposition gebracht werden, von der aus die Y-Reißlinien nacheinander abgetastet werden, worauf der Werktisch in eine andere Referenzposition mit der neuen Y-Koordinate gebracht wird. Aus dieser letzteren Referenzposition müssen nacheinander die X-Reißlinien abgetastet werden, und der Werktisch muß in die zweite adressierte Position mit den neuen X- und Y-Koordinaten bewegt werden. Hinzu kommt, daß dieser Stepper eie Genauigkeit von der Orthogonalität der Y-Achsen-Lageunterstützung des Werktisches bezüglich der X-Bewegungsachse des Werktisches abhängt. Zwar kann diese Orthogonalität mit gegügender Genauigkeit beherrscht werden, erfordert jedoch aufwendige Komponenten hierfür.

Es ist ferner im Stand der Technik bei derartigen adressierbaren Positioniervorrichtungen bekannt, einen am Werktisch befestigen Spiegel vorzusehen. Auf diesen Spiegel wird längs eines optischen Pfades ein Laserstrahl so gerichtet, daß X- und Y-Interferenzringe des Laserstrahls erzeugt werden. Diese Interferenzringe werden zum genauen Positionieren des Werktisches und damit des Werkstückes in die X- und Y-Koordinaten der adressierten Position gezählt (DE—A—2 557 675, DE—A—2 707 477).

Bei dieser Vorrichtung tritt die Schwierigkeit auf, daß der Maßstab zum Bestimmen der X- und Y-Koordinaten einer adressierten Position des Werkstücks von der Wellenlänge des Laserstrahles gebildet ist. Die Wellenlänge des Laserstrahls ist jedoch eine Funktion der Temperatur, des Druckes und der Feuchtigkeit des verwendten optischen Pfades zum Erzeugen der Interferenzringe. Infolgedessen muß der Werktisch in einer Klimakammer untergebracht sein, in welcher Temperatur, Druck und Feuchtigkeit mit hoher Genauigkeit konstant gehalten werden können. Eine solche Klimakammer ist relativ kostspielig und verkompliziert die adressierbare Positioniervorrichtung und ihre Verwendung.

Der Erfindung liegt daher die Aufgabe zugrunde, eine weniger aufwendige und weniger komplizierte adressierbare Positioniervorrichtung der beschribenen Art zu schaffen, die es ermöglicht, eine Bearbeitungsstation nacheinander in einer Folge von wiederholbaren Adressenstellen mit einer Genauigkeit von weniger als 1/10 Mikrometer zu positionieren. Dabei soll die adressierbare Bearbeitungsstation zwischen zwei Adressenstellen auf direkterem Weg bewegt werden, um die Suchzeit zwischen den aufeinanderfolgenden Adressenstellen klein zu halten.

Zur Lösung dieser Aufgabe sind gemäß der Erfindung die Merkmale des Kennzeichens des Anspruchs 1 vorgesehen.

Vorteilhafte Ausgestaltungen der Erfindung sind in den Unteransprüchen unter Schutz gestellt.

Im folgenden wird die Erfindung anhand eines in der Zeichnung dargestellten Ausführungsbeispieles näher erläutert. Es zeigen:

Fig. 1 ein perspektivische Ansicht einer für die Anwendung der Erfindung geeigneten im schrittweisen Reihenbetrieb arbeitenden Maskenausrichtvorrichtung,

Fig. 2 eine teilweise in Blockform dargestellte schematische perspektivische Ansicht der Maskenausrichtungsvorrichtung nach Fig. 1,

Fig. 3 eine vergrößerte Ansicht des Ausschnittes 3—38 in Fig. 2,

Fig. 4 den Verlauf der Ausgangsspannung der Abfühlvorrichtung bei einer Bewegung der Bearbeitungsstation in X-Richtung,

Fig. 5 den Verlauf des aufgearbeiteten Ausgangssignales nach Fig. 4,

Fig. 6 den Verlauf des Ausgangssignales der Abfühlstation im verriegelten Zustand, wenn die Abfühlstation die Bearbeitungsstation an der Bezugsadresse verriegelt,

Fig. 7 den Verlauf der Signalintensität I der Grenzmarken-Abfühlvorrichtung in Abhängigkeit von dem Abstand d vom Rand und

Fig. 8 ein Schlatbild der Grenzmarken-Abfühlvorrichtung für die Grenzmarken in X- und Y-Richtung.

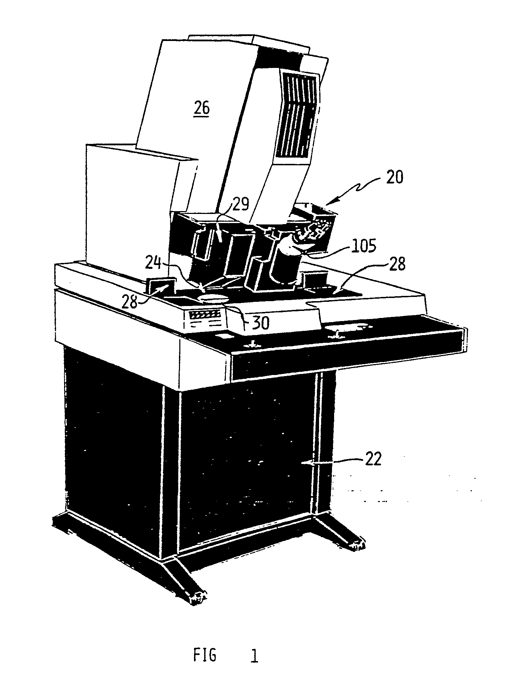

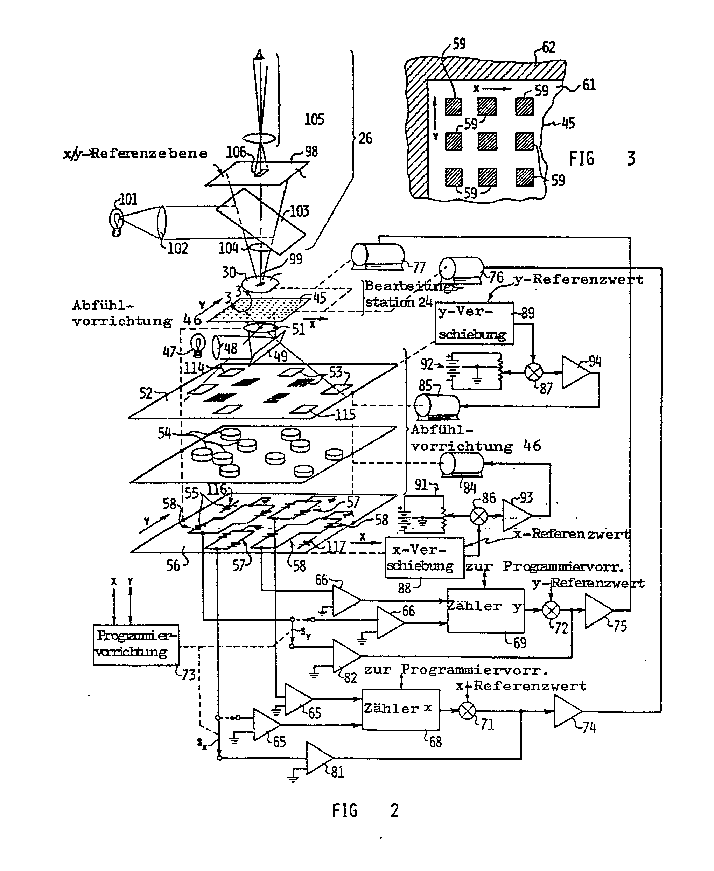

In den Fig. 1 und 2 ist eine im schrittweisen Reihenbetrieb arbeitenden Maskenausricht- und -belichtunsmachine 20 dargestellt, welche die Merkmale der vorliegenden Erfindung enthält. Die Maschine 20 umfaßt eine Basis 22 und eine Präzisions-Bearbeitungsstation 24 auf der Basis 22, welche ein Werkstück 30 aufzunehmen und dieses in einer horizontalen Ebene in zwei zueinander senkrechten Koordintenrichtungen genau zu positionieren vermag. Auf der Basis 22 befindet sich weiterhin eine optische Einheit 26. Für die Bewegung der Werkstücke 30, beispielsweise Halbleiterscheiben, zur Bearbeitungsstation 24 ist eine automatische Werkstück-Hantiervorricutung 28 vorgesehen.

Die Basis 22 enthält einen großen Granitblock 10, dessen Oberseite als Bezugsfläche mit einer Genauigkeit von einem Mikrometer bearbeitet worden ist und der eine senkrecht durchgehende zylindrische Bohrung für die Aufnahme einer optischen Abfühlvorrichtung 46 aufweist.

Beim Betrieb führt die Bedienungsperson ein Werkstück 30, beispielsweise eine Halbleiterscheibe, in die Maschine 20 ein, welche dann das Werkstück auf der Bearbeitungsstation 24 genau positioniert. Die Bedienungsperson bewegt ein Mikroskop 105 der optischen Einheit 26 in eine geeignete Lage zur Betrachtung einer Maske 98, die mit einer adressierten Stelle der Halbleiterscheibe 30 optische genau ausgerichtet werden soll, um die Halbleiterscheibe 30 einer Belichtung mit dem Muster der Maske 98 auszusetzen. Die Bedienungsperson wählt dazu einen Bezugsadressenteil der Halbleiterscheibe 30 aus, der das durch die Maske 98 projizierte Belichtungsmuster aufnehmen soll. Mit der Bearbeitungsstation 24 ist je ein X- und Y-Servomotor 76, 77 verbunden, der die Bearbeitungsstation 24 so bewegt, daß eine Positioniermarkenanordnung 45 der Bearbeitungsstation über die stationäre optische Abfühlvorrichtung 46 innerhalb des Granitblocks 10 zur Ausrichtung gelangt. Die Bedienungsperson betrachtet dabei die Halbleiterstelle an der Bezugsadresse, die von der optischen Einheit 26 beleuchtet wird. Das Abbild der adressierten Stellen der Halbleiterscheibe wird auf die Rückseite der Maske 98 projiziert, um das Abbild der Maske und das Abbild der adressierten Stelle der Halbleiterscheibe zu überlagern. Die Bedienungsperson betrachtet die überlagerten Abbilder durch das Mikroskop 105 und die Maske 98 und betägt die Steuereinrichtungen so, daß die Lage der Abfühlvorrichtung 46 etwas verändert und damit die Lage der Bearbeitungsstation 24 geringfügig korrigiert wird, um das Muster auf der Halbleiterscheibe 30 mit dem Muster der Maske 98 genau auszurichten. Gleichzeitig wird auch die adressierte Stelle auf Null bezogen, indem ein interpolierter Wert für die X- und Y-Koordinaten der adressierten Stelle der Halbleiterscheibe 30 erzeugt wird.

Anschließend schiebt die Bedienungsperson das Mikroskop 105 zur Seite und eine Projektionslichtquelle 29 in die richtige Lage in der optischen Einheit 26. Die Halbleiterscheibe 30 wird mit dem Abbild der Maske 98 durch eine Projektionslinse belichtet und dann an die nächste Belichtungsadresse bewegt. Hierzu führt die Bedienungsperson die nächste Adresse in eine Programmiervorrichtung 73 ein, welche die Bearbeitungsstation 24 an die nächste Bezugsadresse führt, die in dem vorausgegangenen Ausrichtungsschritt auf Null bezogen worden war. Die Halbleiterscheibe wird nacheinander in diesem schrittweisen Reihenbetrieb belichtet, bis die Bedienungsperson oder die Programmiervorrichtung 73 die Hantiervorrichtung 28 betätigt, um die belichtete Halbleiterscheibe zu entfernen und eine neue Halbleiterscheibe in die richtige Lage auf der Bearbeitungsstation 24 zu bringen.

In Fig. 2 ist die adressierbare Werkstück-Positioniervorrichtung mit den Merkmalen der Erfindung genauer dargestellt. Die Halbleiterscheibe 30 ist an der in der X-Y-Ebene bewgbaren Bearbeitungsstation 24 befestigt, die eine mit ihr bewegbare Positioniermarkenanordnung 45 trägt. Unterhalb der Positioniermarkenanordnung 45 ist die stationäre Abfühlvorrichtung 46 innerhalb der zylindrischen Bohrung des Granitblockes 10 angeordnet. Das Licht einer Lampe 47 wird durch eine Linse 48 auf einen Strahlenteiler 49 gerichtet, der es durch eine Vergrößerungslinse 51 auf einen relativ kleinen Bereich der X-Y-Positioniermarken lenkt.

Das Abbild der Positioniermarkenanordnung 45 wird über die Vergrößerungslinse 51 durch den Spiegel des Strahlenteilers 49 projiziert und auf eine Abfühlfensterplatte 52 fokussiert, welche eine Anzahl Mustererkennungsfenster 53 für die Wiedererkennung der X- und Y- Positioniermarken aufweist. Die Linse 51 vergrößert beispielsweise dreizehnfach, so daß das auf die Fensterplatte 52 projizierte Abbild der Positioniermarken dreizehnmal so groß ist wie in Wirklichkeit. Die Fensterplatte 52 enthält eine Anzahl verschiedener Mustererkennungsfenster 53, die das Licht auf mit ihnen ausgerichtete Stecklinsen 54 gelangen lassen. Die Stecklinsen 54 fokussieren das Licht auf eine entsprechende Anzahl von PIN-Dioden 55, die auf einer Diodenplatte 56 der Abfühlvorrichtung 46 angeordnet sind.

Für das Abfühlen der X-Koordinaten der Positioniermarkenanordnung 45 sind zwei Paare 57 der Dioden 55 vorgesehen und in gleicher Weise zwei Paare 58 von Dioden 55 für das Abfühlen der Y-Koordinaten. Die beiden Dioden jedes Diodenpaares 57, 58 sind mit entgegengesetzter Polarität parallel geschaltet, um ein Ausgangssignal mit dem Wert Null zu erreichen, wenn beide Dioden eines Diodenpaares gleich stark beleuchtet werden.

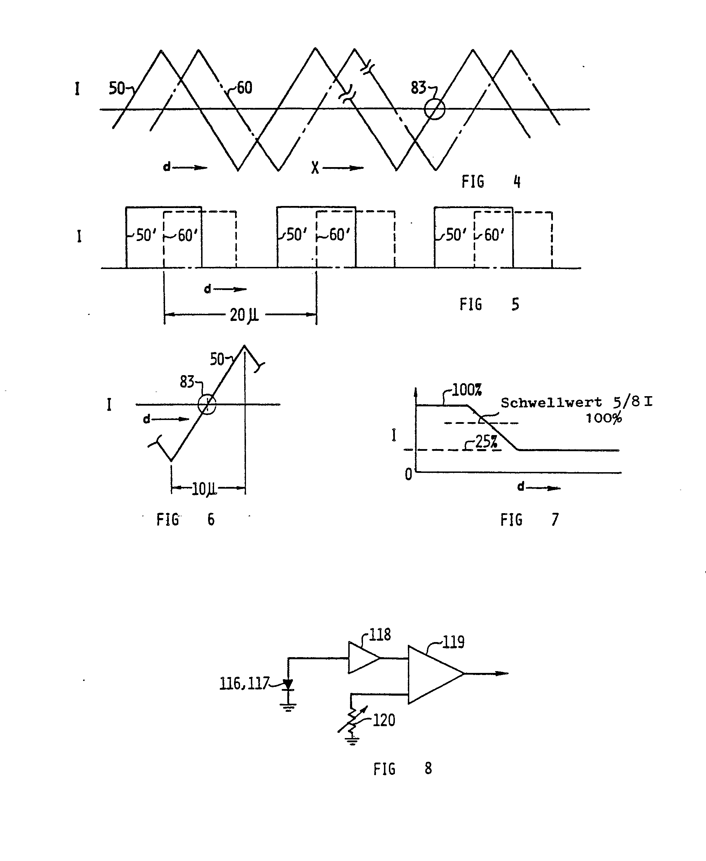

In Fig. 3 ist eine Anordnung von X- und Y-Positioniermarken 59 dargestellt, die im vorliegenden Fall aus quadratischen Punkten einer Chromschicht auf einer gebrannten silikaplatte 61 bestehen. Eine Grenzmarke 62 aus der Chromschicht umrandet die Anordnung der X- un Y-Positioniermarken 59. Die Marken 59 sind in Zeilen und Spalten angeordnet, wobei die X-Koordinaten den Spalten und die Y-Koordinaten den Zeilen entsprechen. Auf diese Weise ist jede adressierbare Stelle der Bearbeitungsstation 24 durch eine bestimmte Markierung 59 festgelegt, deren Spaltennummer der X-Koordinate und deren Zeilennummer der Y-Koordinate entspricht. In dem Ausführungsbeispiel sind die Marken 59 quadratische Punkte mit zehn Mirometer Kantenlänge und 20 Mikrometer Mittenabstand sowhol in der X- als auch in der Y-Richtung.

Die Spalten- und Zeilen-Mustererkennungsfenster 53 in der Fensterplatte 52 bestehen aus zwei Arten. Die erste Fensterart ist ein durchsichtiges Rechteck mit 100×120 Mikron Kantenlänge und entspricht einer Unteranordnung von 5×6 Marken 59. Sie tritt paarweise mit einer zweiten Fensterart auf, die aus einer Anordnung von acht langgestreckten, parallelen schlitzartigen Fenstern besteht, die ein Breite von 10 Mikrometer und einen Mittenabstand von 20 Mikrometer aufweisen und von denen sechs eine Länge von 160 Mikrometer und zwei eine Länge von 120 Mikrometer besitzen, so daß jeweils acht bzw. sechs Marken 59 durch jeden Fensterschlitz der Anordnung betrachtet werden können. Auf diese Weise können durch die Fenster mit der Schlitzanordnung 60 Marken 59 beobachtet werden und durch die normalen rechteckigen Fenster 30 Marken 59. Die transparenten Bereiche beider Fensterarten haben jedoch die gleiche Größe.

Die Ausgangssignale der gegeneinander geschalteten Diodenpaare 57, 58 sind Null, wenn die parallel zu den schlitzartigen Fenstern der Mustererkennungsfenster 53 ausgerichteten Marken 59 zur Hälfte von dem undurchsichtigen Abstand zwischen zwei schlitzartigen Fenstern abgedeckt sind und der eine Rand jedes schlitzartigen Fensters mit der Mittellinie der jeweils betrachteten Punkspalte bzw. Reihe zusammenfällt. Die Längsrichtung der schlitzartigen Fenster liegt dabei senkrecht zu der Abfühlrichtung.

Wie in Fig. 4 dargestellt, erzeugt jedes Diodenpaar 57, 58 einen dreieckförmigen Ausgangsstrom 50, 60, wenn die Bearbeitungsstation 24 bewegt wird. Weiterhin sind die den Diodenpaaren 57, 58 entsprechenden Fensterpaare in der Fensterplatte 52 in der jeweiligen X- oder Y-Richtung gegenüber den anderen Fensterpaaren um ein Viertel der Periode der auf die Fensterplatte 52 projizierten vergrößerten Marken 59 versetzt, d.h. um 5 Mikrometer. Diese Versetzung um 25% verursacht eine Phasenverschiebung der elektrischen Signale 50 und 60 um 90°, wenn dabei die Bearbeitungsstation 24 in der positiven X-Richtung bewegt wird, eilt das Ausgangssignal 50 des ersten Diodenpaars 57 dem Ausgangssignal 60 des zweiten Diodenpaars 57 voraus, während das Ausgangssignal 60 dem Ausgangssignal 50 vorauseilt, wenn die Bearbeitungsstation 24 in der negativen X-Richtung bewegt wird. Jeder Zyklus der Ausgangssignale 50, 60 entspricht dabei dem Zählen einer bestimmten Spalte bzw. Zeile.

In ähnlicher Weise sind die beiden Diodenpaare 58 und die zugehörigen Mustererkennungsfenster 53 auf der Diodenplatte 56 bzw. der Fensterplatte 52 um 1/4 des vergrößerten Abstandes der auf die Fensterplatte 52 projizierten Marken in der Y-Richtung versetzt, um eine 90° Phasenverschiebung der Ausgangssignale ähnlich der in Fig. 4 dargestellten zu erzielen.

Die Ausgangssignale der Diodenpaare 57, 58 werden über Verstärker und Entzerrer 55, 56 geführt, welche das dreieckförmige Ausgangssignal 50, 60 in das Rechtecksignal 50', 60' gemäß Fig. 5 umwandeln. Auf diese Weise wird für jede auf der Fensterplatte 52 abgefühlte Zeile bzw. Spalte von Positioniermarken ein Rechteckimpuls erzeugt. Wenn die Ausgangssignale 50', 60' der Verstärker und Entzerrer 65, 66 von einem ersten Diodenpaar denjenigen eines zweiten Diodenpaares vorauseilen, was einer Bewegung in positiver X- oder Y-Richtung entspricht, werden zwei Zähler 68, 69 für die X- bzw. Y-Koordinaten so umgeschaltet, daß sie die Ausgangssignale der Verstärker 65, 66 für die Spalten bzw. Zeilen in positiver Richtung zählen, wohingegen die Zähler 68, 69 in die negative Zählrichtung umgeschaltet werden, wenn die Ausgangssignale 50' des ersten Diodenpaars den Ausgangssignalen 60' des zweiten Diodenpaars nacheilen.

Die Ausgangssignale der X- und Y-Zähler 68, 69 werden an Fehlerschaltungen 71, 72 für den Vergleich mit den X- und Y-Koordinaten einer Bezugsadresse von der Programmiervorrichtung 73 weitergeleitet, die von der Bedienungsperson programmiert worden ist, um vorbestimmte Adressen von Werkstückstellen auszuwählen. Das Fehlerausgangsignal von den Fehlerschaltungen 71, 72 wird an entsprechende Servoverstärker 74, 75 weitergeleitet, deren Ausgang an entsprechende X- bzw. Y-Servomotoren 76, 77 angeschlossen ist, mit denen die Bearbeitungsstation 24 so verschoben werden kann, daß das Fehlersignal am Ausgang der Fehlerschaltungen 71, 72 auf Null zurückgeht.

Die Programmiervorrichtung 73 verfolgt jeweils die gezählte Anzahl von Zeilen und Spalten sowie die verbleibende Anzahl von Zeilen und Spalten, um die adressierten X- und Y-Koordinaten zu erreichen, und steuert auch die Drehzahl der Servomotoren 76, 77 für die Bewegung der Bearbeitungsstation 24, um sicherzustellen, daß vorbestimmte Grenzen für die Beschleunigung und Abgrenzung nicht überschritten werden. Im Ausführungsbeispiel steuert die Programmiervorrichtung 73 die Beschleunigung und Abbremsung auf ein Zehntel der Erdbeschleunigung. Wenn weiterhin die Fehlerzählung eine Zeile bzw. Spalte vor der jeweiligen ausgewählten Koordinate der adressierten Stelle angelangt ist, betätigt die Programmiervorrichtung 73 die Schalter $S_x$ bzw. $S_y$, um mit den Servomotoren 75, 76 den Anhaltepunkt für die entsprechenden X- und Y-Positionen auf einen Kreuzungspunkt 83 des Ausgangssignals 50 der Diodenpaare 57, 58 zu verriegeln, wie er bei 83 in den Fig. 4 und Fig. 6 dargestellt ist.

Die Ausgangssignale zweier dann angeschlossener Servoverstärker 81, 82 gelangen an den Eingang der Servoverstärker 74, 75, so daß die Servomotoren 76, 77 am Kreuzungspunkt 83 verriegelt werden. Der Kreuzungspunkt 83 entspricht dem Mittelpunkt eines 10 Mikrometer breiten Bereiches auf dem Werkstück sowohl in X- als auch in Y-Richtung. Er ist genau festgelegt mit einer Wiederholgenauigkeit von 1/10 Mikrometer. Auf diese Weise kann die Bearbeitungsstation 24 so programmiert werden, daß sie zu einer Anzahl adressierbarer Stellen auf der Oberfläche des Werkstückes 30 bewegt werden kann, die sowohl in X- als auch in Y-Richtung mit einem Abstand von 20 Mikrometer angeordnet sind. Weiterhin können diese adressierten Stellen wiederholt mit einer Genauigkeit von einem Zehntel Mikrometer erreicht werden.

Die ausgewählten Adressenstellen können auch interpoliert werden, d.h. um plus oder minus 20 Mikrometer sowohl in der X- als auch in der Y-Richtung gegenüber einem festen Punkt auf dem Granitblock 10 verschoben werden, indem eine relativ geringe Verlagerung der Abfühlvorrichtung 46 gegenüber dem Granitblock 10 durchgeführt wird. Hierzu ist die Abfühlvorrichtung 46 zusammen mit der Fensterplatte 52 sowohl in X- als auch in Y-Richtung mit Hilfe von Servomotoren 84, 85 verschiebbar, welche von den Ausgangssignalen zweier Fehlerschaltungen 86, 87 gesteuert werden. Die Ausgangssignale zweier linear veränderbarer Differentialtransformatoren 88, 89 für eine Verschiebung in X- bzw. Y-Richtung, die zum Feststellen von Verschiebungen der Abfühlvorrichtung 46 in X- und Y-Richtung fest auf den Granitblock 10 zurückbezogen sind, werden an die Fehlerschaltungen 86, 87 weitergeleitet, um einen Vergleich mit Bezugssignalen durchzuführen, die unter der Steuerung der Bedienungsperson von X- bzw. Y-Bezugspotentiometern 91, 92 abgenommen werden. Die Fehlersignale der Fehlerschaltungen 86, 87 werden über Servoverstärker 93, 94 den Servomotoren 84, 85 zugeführt.

Auf diese Weise ermöglichen die Potentiometer 91, 92 eine Interpolation der ausgewählten Adressenkoordinaten X und Y auf weniger als 1/10 Mikrometer.

In dem anhand Fig. 2 beschriebenen Ausführungsbeispiel kann die Bedienungsperson über die Potentiometer 91, 92 Einfluß auf die Interpolation nehmen. In einem vollautomatisierten Werkstückspositioniersystem wird jedoch vorteilhafterweise das Bezugssignal für die Interpolation der Adressenstelle zum Vergleich mit den Ausgangssignalen der Differenztransformatoren 88, 89 durch die Programmiervorrichtung 73 ausgewählt.

Die von der Bedienungsperson gesteuerte Interpolation der X- und Y-Koordinaten der adressierten Stelle der Halbleiterscheibe 30, wie sie durch die Potentiometer 91 und 92 ermöglicht wird, ist besonders vorteilhaft bei der Verwendung in einer im schrittweisen Reihenbetrieb arbeitenden Halbleiterscheiben-Belichtungsmaschine zum Ausrichten der photographischen Maske 98 mit dem Muster an einer ausgewählten Adressenstelle 99 auf der Halbleiterscheibe 30. Hierzu wird die adressierte Stelle auf der Oberfläche der Halbleiterscheibe 30 durch eine Lampe 101 beleuchtet, deren Licht über eine Linse 102, einen Strahlenteilerspiegel 103 und eine Linse 104 auf die adressierte Stelle 99 der Halbleiterscheibe 30 gelangt. Das Abbild der adressierten Stelle 99 auf der Oberflächer der Halbleiterscheibe 30 wird über die Linse 104 auf die Unterseite der Maske 98 geworfen. Es kann dort durch die Maske 98 hindurch mit Hilfe des Mikroskops 105 beobachtet werden. Auf diese Weise kann die Bedienungsperson durch das Mikroskop 105 einen kleinen Teil 106 der Maske 98 zusammen mit einem kleinen überlagerten Teil 99 der Halbleiterscheibe 30 betrachten.

Wenn die Halbleiterscheibe 30 bereits einige Bearbeitungsschritte hinter sich hat, kann an der Stelle 99 der Halbleiterscheibe 30 bereits ein Schaltungsmuster zusammen mit dem entsprechenden Maskenmuster in dem Mikroskop 105 betrachtet werden. Diese überlagerten Abbildungsmuster können durch die Bedienungsperson durch Einstellen der Potentiometer 91 und 92 in genaue Übereinstimmung gebracht werden, wobei der Fehler geringer ist als 1/10 Mikrometer. Dies wird dadurch erreicht, daß die Maske 98 hinsichtlich der X- und Y-Koordinaten gegenüber dem stationären Granitblock 10 stationär ist, und die beleuchtete Stelle 99 auf der Halbleiterscheibe 30 relativ zur Maske 98 und dem Granitblock 10 bewegt wird, wobei die Bewegung der Halbleiterscheibe 30 durch die Servomotoren 76, 77 und die zugehörigen Servoschleifen mit der Bewegung der Abfühlvorrichtung 46 verriegelt wird.

Die Interpolierte und adressierte Halbleiterscheibe 30 wird dann durch Projektion des Maskenabbildes über die Linse 104 mit dem Muster der Maske 98 belichtet. Die interpolierte oder auf Null bezogene Adresse ist dann ein Bezugspunkt, von welchem die Programmiervorrichtung 73 die Bearbeitungsstation 24 automatisch schrittweise auf andere vorbestimmte Adressenstellen positioniert, die auf der Halbleiterscheibe einen von der Größe des Abbildes der Maske auf der Halbleiterscheibe abhängigen Abstand aufweisen. Dieses im schrittweisen Reihenbetrieb arbeitende Belichtungssystem ermöglicht es, geringfügige Anpassungen bei den Adressenstellen vorzunehmen, um kleine Positionierfehler der Halbleiterscheibe 30 auf der Bearbeitungsstation 24 durch die automatische Hantiervorrichtung 28 beim Zuführen der Halbleiterscheibe 30 zu kompensieren.

Wie aus Fig. 2 ersichtlich, wird das Abbild der Positioniermarkenanordnung 45 in einer solchen Weise auf die Fensterplatte 52 projiziert, daß die Y-Bezugslinie, die in Fig. 2 bei der Positioniermarkenanordnung 45 vorne liegt, bei der Fensterplatte 52 hinten zu liegen kommt. In ähnlicher Weise wird die X-Bezugslinie, die bei der Markenanordnung 45 auf der linken Seite liegt, bei der Fensterplatte 52 auf die rechte Seite projiziert. Zum Abfühlen der Y- und X-Grenzmarken 62 sind Grenzmarkenfenster 114, 115 und entsprechende Dioden 116, 117 vorgesehen. Dabei fühlt das Fenser 114 die Y-Grenzmarke und das Fenster 115 die X-Grenzmarke ab.

Das Ausgangssignal der Dioden 116, 117 wird gemäß der Fig. 7 und 8 über einen Verstärker 118 an eine Schwellwertschaltung 119 gegeben, wo es mit einem von einem Bezugspotentiometer 120 gelieferten Bezugssignal verglichen wird und zum Feststellen eines Grenzüberganges ein entsprechendes Ausgangssignal an die Programmiervorrichtung 73 liefert, welcher ein 16 Bit-Mikroprozessor vom Typ 9900 sein kann.

In Fig. 7 ist der Ausgangssignalpegel I der Dioden 116, 117 als Funktion der Lage des betreffenden Fensters gegenüber dem daraufprojizierten Markenabbild dargestellt. Wenn das Grenzmarkenfenster sich vollständig innerhalb des Feldes mit der zweidimensionalen Punktanordnung befindet, liefern die Punkte einen Reflexionsgrad von ungefähr 25%, so daß der Signalpegel I 25% des Maximalwertes besitzt. Wenn jedoch das Abbild so verschoben wird, daß ein Teil der Grenzmarke auf das Fenster projiziert wird, weist die Grenzmarke einen Reflexionsgrad von 100% auf und der Signalpegel I steigt, wie in Fig. 7 gezeigt, auf seinen Maximalwert an. Wenn die Grenzmarke das Grenzmarkenfenster vollständig überdeckt, befindet sich der Signalpegel I bei 100%. Die Schwellwertschaltung 119 ist so eingestellt, daß ein Signalpegel von 5/8 des Maximalwertes ein den Grenzübergang anzeigendes Ausgangssignal auslöst.

Wenn die Maschine eingeschaltet wird, bewirkt die Programmiervorrichtung 73, daß die Bearbeitungsstation 24 in einer solchen Weise verlagert wird, daß die Grenzmarken abgefühlt werden und daß die Spalten- und Zeilen-Zählung in den entsprechenden X- und Y-Zählern auf die Grenzmarken zurückbezogen werden. Das Erreichen der X-Grenzmarke wird von der Programmiervorrichtung 73 dadurch festgestellt, daß die Bearbeitungsstation 24 unter Beibehaltung einer anfänglichen Y-Zeilenadresse in der negativen X-Richtung verschoben wird, bis durch das Grenzmarkenfenster 115 und die Diode 117 ein Grenzmarkenabbild festgestellt wird. Das Schwellwertausgangssignal wird an die Programmiervorrichtung 73 weitergeleitet, um den Ausgang des Spaltenzählers auf die entsprechende X-Grenzmarke zurückzubeziehen. Die Programmiervorrichtung 73 verschiebt jetzt die Bearbeitungsstation 24 unter Beibehaltung der anfänglichen Y-Zeilenadresse in der positiven X-Richtung, bis der Zähler bis zum Mittelpunkt der Bearbeitungsstation 24 gezählt hat. Dann veranlaßt die Programmiervorrichtung 73 die Bearbeitungsstation 24 unter Beibehaltung der mittleren X-Spaltenadresse in der negativen Y-Richtung weiterzugehen, bis das Grenzmarkenfenster 114 und die Diode 116 die Y-Grenzmarke erfaßt. Das Ausgangssignal der Schwellwertschaltung wird wieder zu der Programmiervorrichtung zurückgegeben und setzt die Zeilenzählung an der Y-Grenzmarke auf Null.

Wenn das Diodenpaar 57, wie zuvor anhand der Fig. 4 und 6 beschrieben, mit Hilfe des analogen Kreuzungspunkts 83 die Vorrichtung auf die X-adressierten Marken verriegelt, verwendet es dasjenige Diodenpaar, das am weitesten von der entsprechenden Abfühldiode 116 für die Y-Grenzmarke entfernt ist, um ein Abfühlen der Grenzmarke und ein Anhalten der Bewegung der Bearbeitungsstation zu ermöglichen, während diese an der gewünschten adressierten Spalte verriegelt wird. In ähnlicher Weise ist das für die Verriegelung der adressierten Zeilenmarken verwendete Diodenpaar 58 aus den gleichen Gründen dasjenige, das am weitesten von der Abfühldiode 117 für die X-Grenzmarke entfernt ist.

Die beschriebene in der X- und Y-Richtung adressierbare Werkstück-Positioniervorrichtung hat insbesondere in einer Maskenausricht- und Belichtungsmaschine den Vorteil, daß das Werkstück schrittweise an verschiedene adressierbare Stellen bewegt werden kann, die bis auf einen Zehntel-Mikrometer genau bestimmt werden können. Das schrittweise Weiterbewegen des Werkstückes von einer adressierbaren Stelle zur nächsten erfolgt auf dem kürzesten Weg zwischen den beiden adressierten Stellen und wird durch eine gemeinsame zweidimensionale Anordnung von Positioniermarken genau bestimmt, wodurch die Suchzeit verringert und der Durchsatz der Maschine erhöht wird, während die Genauigkeit der adressierten Stellen durch das genaue Positionieren von X- und Y-Koordinatenmarken genau bestimmt wird, ohne daß die Genauigkeit von dem Grad der Orthogonalität kostspieliger Lagervorrichtungen abhängt und ohne daß genau konstantzuhaltende Klimakammern für Laser-Vorrichtungen erforderlich wären.

Unter einer "zweidimensionalen Anordnung" von Koordinaten-Positioniermarken soll jede Anordnung von Marken in zwei Richtungen verstanden werden. Während also eine Reihe paralleler Linien eine eindimensionale Anordnung ist, wäre eine Reihe von Punkten, die wie in Fig. 3 in zwei Richtungen hintereinander angeordnet sind, genauso eine zweidimensionale Anordnung, wie eine Reihe konzentrischer Ringe mit einer Reihe radialer Speichen.

**Patentansprüche**

1. Adressierbare Positioniervorrichtung mit einem Werktisch (24), der längs zwei Koordinatenachsen (X, Y) bewegbar ist und zum Halten eines Gegenstandes, wie eines Werkstücks, dient, ferner mit einer Sensoranordnung (46), welche für die Ist-Koordinatenstellung des Werktisches repräsentative Ausgangsinformation liefert, sowie mit einer Regelvorrichtung (65, bis 94) mit Vergleichermitteln (71, 72), in welchen die Ausgangsinformation der Sensoranordnung mit Eingangssteuerinformation verknüpft wird, um den Werktisch in durch die Eingangssteuerinformation vorbestimmte Soll-Koordinatenstellungen zu bringe, dadurch gekennzeichnet, daß mit dem Werktisch (24) ein zweidimensionales Positionsmarkenfeld (45) bestehend aus Koordinatenpositionsmarken (59) fest verbunden ist, daß eine Projektionsvorrichtung zur Erzeugung eines Abbildes mindestens eines Teiles des Positionsmarkenfeldes (45) auf die Sensoranordnung vorgesehen ist, und daß die Sensoranordnung (46) zum Abfühlen der Koordinatenpositionsmarken (59) im Abbild und Erzeugen einer entsprechenden Ausgangsinformation ausgebildet ist.

2. Positioniervorrichtung nach Anspruch 1, dadurch gekennzeichnet, daß die Regelvorrichtung (65 bis 94) erste Steuermittel (65 bis 82) aufweist, die außer auf die Ausgangsinformation der Sensoranordnung (46) auf Eingangssteuerinformationen reagieren, welche eine Soll-Koordinatenstellung des Werktisches (24) bestimmen, daß die Sensoranordnung (46) ebenfalls längs zweier Koordinatenachsen (X, Y) beweglich ist und daß die Regel vorrichtung (65 bis 94) ferner zweite Steuermittel (84 bis 94) aufweist, um die Sensoranordnung derart zu bewegen, daß sie eine Bewegung des Werktisches (24) zum Interpolieren der Soll-Koordinatenposition bewirkt.

3. Positioniervorrichtung nach Anspruch 2, dadurch gekennzeichnet, daß sie eine Detektorvorrichtung (88, 89) zum Erzeugen von Ausgangsinformationen aufweist, welche die Koordinatenstellung der Sensoranordnung (46) bestimmt, und daß die zweiten Steuermittel (84 bis 94) auf die von der Detektorvorrichtung (88, 89) abgegebene Ausgangsinformation sowie Eingangssteuerinformation betreffend eine unterschiedliche interpoliert Koordinatenstellung anspricht, um die Sensoranordnung in die interpolierte Koordinatenstellung zu bewegen und damit eine Bewegung des Werktisches in die interpolierte Stellung der Soll-Koordinatenstellung zu bewirken.

4. Positioniervorrichtung nach einem der Ansprüche 2 oder 3, dadurch gekennzeichnet, daß die ersten und zweiten Steuermittel (65 bis 82, 84 bis 94) gemeinsam zum Bewegen des Werktisches (24) und der Sensoranordnung (46) eingesetzt werden, um eine Bewegung des Werktisches in eine interpolierte Stellung der Soll-Koordinatenstellung zu bewirken.

5. Positioniervorrichtung nach Anspruch 4, dadurch gekennzeichnet, daß der Werktisch (24) mit der Sensoranordnung (46) zu einer Bewegung in Abhängigkeit von der Bewegung der Sensoranordnung kuppelbar ist.

6. Positioniervorrichtung nach Anspruch 5, dadurch gekennzeichnet, daß die ersten Steuermittel (65 bis 82) Schaltmittel ($S_x$, 81; $S_y$, 82) aufweisen, die betätigt werden, wenn der Werktisch innerhalb einer vorbestimmten Toleranz der Soll-Koordinatenstellung bewegt wird, um den Werktisch relativ zur Bewegung der Sensoranordnung zu bewegen.

7. Positioniervorrichtung nach Anspruch 6, dadurch gekennzeichnet, daß die zweiten Steuermittel (84 bis 94) zum Bewegen der Sensoranordnung (46) eingesetzt werden, um eine Bewegung des Werktisches (24) zur Interpolationsstelle der Soll-Koordinatenstellung zu bewirken.

8. Positioniervorrichtung nach einem der Ansprüche 2 bis 7, dadurch gekennzeichnet, daß die ersten Steuermittel (65 bis 82) zum aufeinanderfolgenden Bewegen des Werktisches (24) in unterschiedliche Soll-Koordinatenstellungen betätigbar ist, um nacheinander unterschiedliche Gebiete des Gegenstandes (30) zu adressieren.

9. Positioniervorrichtung nach einem der Ansprüche 4 bis 8, dadurch gekennzeichnet, daß die zweiten Steuermittel (84 bis 94) variable Eingangsmittel (88, 89) zum Erzeugen von Eingangsinformation aufweisen, welche für die interpolierte Koordinatenstellung der Sensoranordnung (46) bestimmend ist, daß Vergleichermittel (86, 87) auf die Ausgangsinformation der Detektormittel und die Eingangssteuerinformation aus den variablen Eingangsmitteln reagieren, um ein Fehlersignal zu bilden, und daß Antriebsmittel (84, 93; 85, 94) vorgesehen sind, welche mit der Sensoranordnung gekuppelt sind und auf das Fehlersignal aus den Vergleichermitteln (86, 87) reagieren, um die Sensoranordnung (46) in die interpolierte Koordinatenstellung zu bewegen und eine Bewegung des Werktisches (24) in die interpolierte Stellung der Soll-Koordinatenstellung zu bewirken.

10. Positioniervorrichtung nach Anspruch 9, dadurch gekennzeichnet, daß die Detektormittel (88, 89) ein Paar linear veränderliche Differentialwandler aufweisen, von denen jeder Ausgangsinformation liefert, die eine entsprechend unterschiedliche Koordinate gegenüber der Ist-Koordinatenstellung der Sensoranordnung (46) bestimmt; daß die variablen Eingangsmittel ein Paar Potentiometer (91, 92) umfassen, von denen jedes Eingangssteuerinformationen liefert, die ein entsprechende unterschiedliche Koordinate der interpolierten Koordinatenstellung der Sensoranordnung (46) bestimmt; daß die vergleichermittel (86, 87) ein Paar Vergleicher umfaßt, von denen jeder auf entsprechende unterschiedliche Ausgangsinformation der linear veränderbaren Differentialwandler (88, 89) und die Eingangssteuerinformation eines der Potentiometer (91, 92) reagiert, um ein Fehlersignal zu bilden; und daß die Servoantriebsmittel (84, 95; 85, 94) ein Paar Servomotoren (84, 85) umfassen, von denen jeder mit der Sensoranordnung (46) gekoppelt ist und auf ein Fehlersignal reagiert, das von je einem der Vergleicher (86, 87) stammt, um die Sensoranordnung (46) längs einer unterschiedlichen Koordinatenachse (X, Y) zu einer entsprechenden unterschiedlichen Koordinate der interpolierten Koordinatenstellung der Sensoranordnung (46) zu verlagern.

11. Positioniervorrichtung nach einem der Ansprüche 4 bis 10, dadurch gekennzeichnet, daß die ersten Steuermittel (65, bis 82) Steuereingangsmittel für die Eingangssteuerinformation, welche die Soll-Koordinatenstellung des Werktisches (24) bestimmt; die Vergleichsmittel (71, 72), welche auf die Ausgangsinformation der Sensoranordnung (46) und die Eingangssteuerinformation aus den Steuereingangsmitteln (73) reagieren, um ein Fehlersignal zu bilden; sowie Servorantriebsmittel (74, 76; 75, 77) umfassen, die mit dem Werktisch (24) gekoppelt sind und auf das Fehlersignal aus den zuletzt genannten Vergleichsmitlen (71, 72) reagieren, um den Werktisch (24) innerhalb einer vorgewählten Toleranz der Soll-Koordinatenstellung zu bewegen.

12. Positioniervorrichtung nach einem der Anspruche 2 bis 11 dadurch gekennzeichnet, daß die ersten Steuermittel (65 bis 82) ferner erste Verstärkermittel (65, 66) zum Empfangen und Verstärken der Ausgangsinformation aus der Sensoranordnung (46) sowie Zählermittel (68, 69) aufweisen, welche auf die verstärkte Ausgangsinformation aus den ersten Verstärkermitteln (65, 66) reagieren, um die zuletzt genannten Vergleichsmittel (71, 72) mit Eingangstellinformation zu speisen, welche die Stellung des Werktisches (24) anzeigt.

13. Positioniervorrichtung nach Anspruch 12, dadurch gekennzeichnet, daß die Schaltmittel ($S_X$, 81; $S_Y$, 82) zweite Verstärkermittel (81, 82) zum Empfangen und Verstärken eines Teils der Ausgangsinformation der Sensoranordnung (46) und ferner Schalter ($S_X$, $S_Y$) aufweisen, die betätigt werden, wenn der Werktisch (24) in der vorgewählten Toleranz der Soll-Koordinatenposition bewegt wird, um den genannten Anteil der Ausgangsinformation von den ersten Verstärkermittel (65, 66) zu den zweiten Verstärkermitteln (81, 82) umzuschalten; und daß die zuletzt genannten Servoantriebsmittel (74, 76; 75, 77) auf den verstärkten Anteil der Ausgangsinformation aus den zweiten Verstärkermitteln (81, 82) reagiert, um den Werktisch (24) in die Soll-Koordinatenposition zu bewegen.

14. Positioniervorrichtung nach einem der vorangehenden Ansprüche, dadurch gekennzeichnet, daß die Koordinatenadressiermarken (59) gleichmäßig in Reihen parallel zur einen Koordinatenachse (X) und in Spalten parallel zur anderen Koordinatenachse (Y) angeordnet sind.

15. Positioniervorrichtung nach Anspruch 15, dadurch gekennzeichnet, daß die Koordinatenadressiermarken (59) gleichförmige Größe haben, insbesondere quadratisch ausgebildet sind.

16. Positioniervorrichtung nach Anspruch 14 oder 15, dadurch gekennzeichnet, daß Koordinatenreferenzmarken (62) für das Adressiermarkenfeld (45) mit den Koordinatenadressiermarken vorgesehen sind, wobei die Koordinatenreferenzmarken (62) Randteile eines das Adressiermarkenfeld (45) mit den Koordinatenadressiermarken (59) ungebenden Randes bilden.

17. Positioniervorrichtung nach einem der Ansprüche 14 bis 16, dadurch gekennzeichnet, daß die Koordinatenadressier- und/oder Referenzmarken (59, 62) reflektierende Gebiete aufweisen, die auf einer transparenten Platte ausgebildet sind, welche zwischen der Sensoranordnung (46) und dem Gegenstand bzw. Werkstück (30) angeordnet sind.

18. Positioniervorrichtung nach einem der Ansprüche 14 bis 17, dadurch gekennzeichnet, daß die Sensoranordnung (46) einen ersten Satz von mindestens ersten un zweiten Sensormitteln aufweist, die zum Abfühlen der in zu der einen Achse (X) parallel in Reihen angeordneten Koordinatenadressiermarken (59) angeordnet sind, um für eine Koordinate der Koordinatenstellung des Werktisches (24) bestimmende Ausgangsinformation zu liefern, und daß ein zweiter Satz von mindestens ersten und zweiten Sensormitteln zum Abfühlen der in Reihen parallel zu der anderen Achse (Y) angeordneten Koordinaten-Adressiermarken angeordnet sind, um Ausgangsinformation für die andere Koordinate der Koordinatenstellung des Werktisches (24) zu liefern.

19. Positioniervorrichtung nach Anspruch 18, dadurch gekennzeichnet, daß die Sensormittel des ersten Satzes gegeneinander längs der einen Achse (X) versetzt sind, um für die Koordinatenstellung und die Bewegungsrichtung des Werktisches (24) längs der einen Achse (X) repräsentative Ausgangsinformation zu liefern, und daß die Sensormittel des zweiten Satzes gegeneinander längs der anderen Achse (Y) versetzt sind, um für die Koordinatenposition und Bewegungsrichtung des Werktisches (24) längs der anderen Achse (Y) repräsentative Ausgangsinformation zu liefern.

20. Positioniervorrichtung nach Anspruch 18 oder 19, dadurch gekennzeichnet, daß die Sensormittel je ein transparentes Fenster (53) sowie einen damit zusammenwirkenden Fotodetektor (55) umfassen.

21. Positioniervorrichtung nach Anspruch 20, dadurch gekennzeichnet, daß die Fenster (53) Gruppen paralleler transparenter langgestreckter rechteckiger Bereiche aufweisen, die in einer opaken Platte (52) ausgebildet sind, wobei jeder Bereich eine Längsachse, die orthogonal zu den abzufühlenden Zeilen oder Spalten von Koordinatenadressiermarken (59) steht, gleiche Breite wie diejenige der Zeilen oder Spalten von Koordinatenadressiermarken, eine Länge gleich dem ganzteiligen Vielfachen des Mitte-zu-Mitte-Abstandes entsprechender Zeilen oder Spalten von Koordinatenadressiermarken (59) und einen Mitte-zu-Mitte-Abstand aufweist, der gleich dem ganzteiligen Vielfachen des Mitte-zu-Mitte-Abstandes der entsprechenden Zeilen oder Spalten von Koordinatenadressiermarken (59) ist.

22. Positioniervorrichtung nach einem der Ansprüche 18 bis 21, dadurch gekennzeichnet, daß Kompensationsmittel vorgesehen sind, von denen jedes ein Paar Sensoren zum Kompensieren unerwünschter Schankungen in der Bildintensität umfaßt.

23. Positioniervorrichtung nach Anspruch 22, dadurch gekennzeichnet, daß erste und zweite Photodetektoren (55) jedes Paars Sensoren entgegengesetzt geschaltet sind.

24. Positioniervorrichtung nach einem der Ansprüche 18 bis 23, dadurch gekennzeichnet, daß der este Satz Paare von Sensormitteln versetzt zueinander längs der einen Achse (X) ist, um eine für die Koordinatenstellung und Bewegungsrichtung des Werktisches (24) längs der einen Achse (X) repräsentative Ausgangsinformation zu liefern; und daß der zweite Satz Paare von Sensormitteln versetzt zueinander längs der anderen Achse (Y) ist, um für die Koordinatenstellung und Bewegungsrichtung des Werktisches (24) längs der anderen Achse (Y) repräsentative Ausgangsinformation zu liefern.

25. Positioniervorrichtung nach einem der Ansprüche 19 oder 24, dadurch gekennzeichnet, daß die Sensoranordnung jedes Satzes von Sensormitteln voneinander längs der entsprechenden Koordinatenachse im wesentlichen um ein ungerades Vielfaches von 90° versetzt ist.

26. Positioniervorrichtung nach Anspruch 25, dadurch gekennzeichnet, daß jedes Paar Sensormittel ein transparentes Fenster (53) einer ersten Art, das mit einem zugehörigen ersten Photodetektor (55) zusammenwirkt, und ein transparentes Fenster (53) einer zweiten Art aufweist, das mit einem zugehörigen zweiten Photodetektor (55) zusammenwirkt und eine transparente Fläche hat, die gleich derjenigen des Fensters der ersten Art ist.

27. Positioniervorrichtung nach Anspruch 26, dadurch gekennzeichnet, daß jedes Fenster der ersten Art ein einziges, in der opaken Platte ausgebildetes transparentes Gebiet mit einem oder mehreren rechteckigen Flächen einer Breite und einer Länge gleich einem ganzteiligen Vielfachen des Mitte-zu-Mitte-Abstandes der entsprechenden Zeilen oder Spalten der Koordinatenadressiermarken umfaßt und daß jedes Fenster der zweiten Art eine Gruppe paralleler transparenter, langgestreckter, rechteckiger Gebiete in der opaken Platte hat, wobei jedes Gebiet eine senkrecht zu den entsprechenden Zeilen oder Spalten der abzufühlenden Koordinatenadressiermarken stehende Längsachse, eine der entsprechenden Zeilenbreite oder Spaltenbreite der Koordinatenadressiermarken gleiche Breite und eine Länge aufweist, die gleich einem ganzteiligen Vielfachen des Mitte-zu-Mitte-Abstandes der entsprechenden Reihen oder Spalten der Koordinatenadressiermarken ist.

28. Positioniervorrichtung nach einem der Ansprüche 18 bis 27, dadurch gekennzeichnet, daß Sensormittel (114, 116; 115, 117) zum Abfühlen der Koordinatenreferenzmarken (62) vorgesehen sind, um Ausgangsinformation zum Zuordnen zu den gefühlten Koordinatenadressiermarken zu erzeugen.

29. Positioniervorrichtung nach Anspruch 28, dadurch gekennzeichnet, daß das Koordinatenadressierfeld (45) mit Koordinatenadressiermarken (53) einen optischen Reflexions- oder Übertragungskoeffizienten einer ersten Größe aufweist, daß die Koordinatenreferenz marken (62) je einen optischen Reflexions- oder Übertragungskoeffizienten einer zweiten Größe aufweisen und daß die Sensormittel (114, 116; 115, 117) zum Abfühlen der Referenzmarken einen optischen Reflexions- oder Übertragungskoeffizienten zwischen der ersten und der zweiten Größe aufweisen.

30. Positioniervorrichtung nach Anspruch 28 oder 29, dadurch gekennzeichnet, daß der Werktisch (24) nacheinander in eine erste Koordinatenstellung, in welcher eine Koordinatenreferenzmarke (62) von den ersten Sensormitteln (114, 116) abgefühlt wird, während die Koordinatenadressiermarken (59) durch die hierfür vorgesehenen Sensormittel (53, 55) abgefühlt werden, und in eine zweite Koordinatenposition verlagert wird, in welcher die andere Koordinatenreferenzmarke (62) mittels der zweiten Sensormittel (115, 117) abgefühlt werden, während die Koordinatenadressiermarken (59) mittels der hierfür bestimmten Sensormittel (53, 55) abgefühlt werden.

31. Positioniervorrichtung nach Anspruch 30, dadurch gekennzeichnet, daß die Sensormittel zum Abfühlen der Referenzmarken (62) ein Paar transparente Fenser (114, 115) der ersten Art aufweisen, von denen jedes mit einem zugehörigen Photodetektor (116, 117) zusammenwirkt.

32. Positioniervorrichtung nach einem der Ansprüche 1 bis 31, dadurch gekennzeichnet, daß optische Mittel (47 bis 51) zum Projizieren eines Abbildes eines Teils des Koordinatenadressiermarkenfeldes (45) auf die Sensoranordnung (46) vorgesehen ist, und daß diese Sensoranordnung (46) zum Abfühlen der Koordinatenadressiermarken in dem Abbild betätigbar ist, um Ausgangsinformation zu liefern, welche repräsentativ für die Koordinatenstellung des Werktisches (24) ist.

33. Positioniervorrichtung nach Anspruch 32, dadurch gekennzeichnet, daß eine Vielzahl von Linsen (54) zwischen jeweils unterschiedlichen Fenstern (53) und zugehörigen Photodetektoren (55) zum Abbilden von Licht mittels der zuletzt genannten optischen Mittel (47 bis 51) über das entsprechende Fenser auf den zugehörigen Photodetektor (55) mit einer Intensität vorgesehen sind, welche durch die Anteile der Koordinatenadressiermarken (59) bestimmt sind, die durch das entsprechende Fenster (53) abgefühlt werden.

## Revendications

1. Dispositif adressable de positionnement comportant une table de travail (24), qui est déplaçable le long de deux axes de coordonnées (X, Y) et sert à retenir un objet, comme par exemple une pièce à usiner, et comportant en outre un dispositif formant capteur (46), qui délivre une information de sortie représentative de la position réelle de coordonnées de la table de travail, ainsi qu'un dispositif de réglage (65 à 94) comportant des moyens comparateurs (71, 72), dans lesquels l'information de sortie du dispositif formant capteur est combinée à une information de commande d'entrée, afin d'amener la table de travail dans des positions de consigne dans le système de coordonnées, prédéterminées par l'information de commande d'entrée, caractérisé par le fait qu'à la table de travail (24) est relié rigidement un champ bidimensionnel (45) de marques de position constituées par des marques (59) de position dans le système de coordonnées, qu'il est prévu un dispositif de projection servant à produire une image d'au moins une partie du champ (45) des marques de position sur le dispositif formant capteur, et que le dispositif formant capteur (46) est agencé de manière à détecter, dans l'image, les marques (50) de position dans le système de coordonnées et à produire une information de sortie correspondante.

2. Dispositif de positionnement selon la revendication 1, caractérisé en ce que le dispositif de réglage (65 à 94) comporte des premiers moyens de commande (65, à 82) qui réagissent non seulement à l'information de sortie du dispositif formant capteur (46), mais également à des informations de commande d'entrée qui déterminent une position de consigne de la table de travail (24) dans le système de coordonnées, que le dispositif formant capteur (46) est également déplaçable le long de deux axes de coordonnées (X, Y) et que le dispositif de réglage (65, à 94) comporte en outre des seconds moyens de commande (84, à 94) permettant de déplacer ledit dispositif formant capteur de manière qu'il provoque un déplacement de la table de travail (24) pour réaliser l'interpolation de la position de consigne dans le système de coordonnées.

3. Dispositif de positionnement selon la revendication 2, caractérisé en ce qu'il comporte un dispositif de détection (88, 89) servant produire les informations de sortie et qui détermine la position du dispositif formant capteur (46) dans le système de coordonnées, et que les seconds moyens (84 à 94) répondent à l'information de sortie délivrée par le dispositif de détection (88, 89) ainsi qu'à une information de commande d'entrée concernant une position interpolée différente dans le système de coordonnées de manière a déplacer le dispositif formant capteur pour l'amener dans la position interpolée dans le système de coordonnées et déclencher de ce fait un déplacement de la table de travail pour l'amener dans la position obtenus par interpolation de la position de consigne dans le système de coordonnées.

4. Dispositif de positionnement selon l'une des revendications 2 ou 3, caractérisé en ce que les premiers et seconds moyens de commande (65 à 82, 84 à 94) sont utilisés en commun pour déplacer la table de travail (24) et le dispositif formant capteur (46), afin de déclencher un déplacement de la table de travail venant dans une position interpolée obtenue par interpolation de la position de consigne dans le système de coordonnées.

5. Dispositif de positionnement selon la revendication 4, caractérisé en ce que la table de travail (24) muni du dispositif formant capteur (46) peut être accouplée à un déplacement s'effectuant en fonction du déplacement du dispositif formant capteur.

6. Dispositif de positionnement selon la revendication 5, caractérisé en ce que les premiers moyens de commande (65 à 82) comportent des moyens de commutation ($S_X$, 81; $S_Y$, 82) qui sont actionnées lorsque la table de travail est déplacée dans les limites d'une tolérance prédéterminée de la position de consigne dans le système de coordonnées, afin de déplacer la table de travail par rapport au déplacement du dispositif formant capteur.

7. Dispositif de positionnement selon la revendication 6, caractérisé en ce que les seconds moyens de commande (84 à 94) servant à déplacer le dispositif formant capteur (46) sont utilisés pour déclencher un déplacement de la table de travail (24) en direction du point d'interpolation de la position de consigne dans le système de coordonnées.

8. Dispositif de positionnement selon l'une des revendications 2 à 7, caractérisé en ce que les premiers moyens de commande (65 à 82) peuvent être actionnés de manière à déplacer successivement la table de travail (24) pour l'amener dans différentes positions de consigne dans le système de coordonnées, afin d'adresser successivement différentes zones de l'objet (30).

9. Dispositif de positionnement selon l'une des revendications 4 à 8, caractérisé en ce que les seconds moyens de commande (84 à 94) possèdent des moyens d'entrée variables (88, 89) pour produire une information d'entrée qui est déterminante pour la position interpolée du dispositif formant capteur (46) dans le système de coordonnées, que des moyens comparateurs (86, 87) réagissent à l'information de sortie des moyens de détection et à l'information de commande d'entrée délivrée par les moyens d'entrée variables pour former un signal d'erreur, et qu'il est prévu des moyens d'entraînement (84, 93; 85, 94), qui sont accouplés au dispositif formant capteur et réagissent au signal d'erreur délivre par les moyens comparateurs (86, 87) de manière à déplacer le dispositif formant capteur (46) pour l'amener dans la position interpolée dans le système de coordonnées et provoquer un déplacement de la table de travail (24), amenant cette dernière dans sa position interpolée obtenue par interpolation de la position de consigne dans le système de coordonnées.

10. Dispositif de positionnement selon la revendication 9, caractérisé en ce que les moyens de détection (88, 89) comportent un couple de transducteurs différentiels variables linéairement, dont chacun délivre une information de sortie qui détermine une coordonnée différente correspondante par rapport à la position réelle du dispositif formant capteur (46) dans le système de coordonnées, que les moyens d'entrée variables comportent un couple de potentiomètres (91, 92), dont chacun délivre des informations de commande d'entrée qui déterminent une coordonnée correspondante différente de ga position interpolée du dispositif formant capteur (46) dans le système de coordonnées, et que les moyens comparateurs (86, 87) comprennent un couple de comparateurs, dont chacun réagit à une information de sortie variable correspondante des transducteurs différentiels (88, 89), modifiables linéairement, et à l'information de commande d'entrée de l'un des potentiomètres (91, 92) de manière à former un signal d'erreur, et que les moyens de servocommande (84, 95; 85, 94) comprennent un couple de servomoteurs (84, 85), dont chacun est accouplé au dispositif formant capteur (46) et réagit à un signal d'erreur qui provient respectivement de l'un des comparateurs (86, 87), de manière à décaler le dispositif formant capteur (46) le long d'un axe de coordonnées différent (X, Y) en direction d'une coordonnée différente correspondante de la position interpolée du dispositif formant capteur (46) dans le système de coordonnées.

11. Dispositif de positionnement selon l'une des revendications 4 à 10, caractérisé en ce que les premiers moyens de commande (65 à 82) comportent des moyens d'entrée de commande pour l'information de commande d'entrée, qui détermine la position de consigne de la table de travail (24) dans le système de coordonnées, les moyens comparateurs (71, 72), qui reagissent à l'information de sortie du dispositif de détection (46) et à l'information de commande d'entrée délivrée par les moyens d'entrée de commande (73) de manière à former une signal d'erreur, ainsi que des moyens de servocommande (74, 76; 75, 77), qui sont accouplées à la table de travail (24) et réagissent au signal d'erreur délivré par les moyens comparateurs (71, 72) indiqués en dernier lieu, de manière à déplacer la table de travail (24) dans les limites d'une tolérance présélectionnée de la position de consigne dans le système de coordonnées.

12. Dispositif de positionnement selon l'une des revendications 2 à 11, caractérisé en ce que les premiers moyens de commande (65 à 82) comportent en outre des premiers moyens amplificateurs (65, 66) servant à recevoir et à amplifier l'information de sortie délivrée par le dispositif formant capteur (46) ainsi que des moyens de comptage (68, 69) qui réagissent à l'information de sortie amplifiée délivrée par les premiers moyens amplificateurs (65, 66) de manière à alimenter les moyens comparateurs (71, 72) indiqués en dernier lieu avec une information de réglage d'entrée, qui indique la position de la table de travail (24).

13. Dispositif de positionnement selon la revendication 12, caractérisé en ce que les moyens de commutation ($S_X$, 81; $S_Y$, 82) comportent des seconds moyens amplificateurs (81, 82) servant à recevoir et à amplifier une partie de l'information de sortie du dispositif formant capteur (46) et en outre des commutateurs ($S_X$, $S_Y$) qui sont actionnées lorsque la table de travail (24) est déplacée dans les limites de la tolérance présélectionnée de la position de consigne dans le système de coordonnées, afin de commuter la partie indiquée de l'information de sortie depuis les premiers moyens amplificateurs (65, 66) en direction des seconds moyens amplificateurs (80, 82), et que les moyens de servocommande (74, 76; 75, 77) indiqués en dernier lieu réagissent à la partie amplifiée de l'information de sortie délivrée par les seconds moyens amplificateurs (81, 82), pour déplacer la table de travail (24) en l'amenant dans sa position de consigne dans le système de coordonnées.

14. Dispositif de positionnement selon l'une des revendications précédentes, caractérisé en ce que les marques (59) d'adressage de coordonnées sont disposées de façon uniforme dans des lignes parallèles à un axe de coordonnées (X) et selon des colonnes parallèles à l'autre axe de coordonnées (Y).

15. Dispositif de positionnement selon la revendication 14, caractérisé en ce que les marques (59) d'adressage de coordonnées possèdent des dimensions uniformes, et notamment sont réalisées avec une forme carrée.

16. Dispositif de positionnement selon la revendication 14 ou 15, caractérisé en ce qu'il est prévu des marques (62) de référence de coordonnées pour la zone (45) de marques d'adressage comportant des marques d'adressage de coordonnées, les marques (62) de référence de coordonnées constituant des éléments marginaux d'un bord entourant la zone (45) des marques d'adressage comportant les marques (59) d'adressage de coordonnées.

17. Dispositif de positionnement selon l'une des revendications 14 à 16, caractérisé en ce que les marques (59, 62) d'adressage et/ou de référence de coordonnées comportent des zones réfléchissantes qui sont disposées sur une plaque transparente qui est située entre le dispositif formant capteur (46) et l'objet ou la pièce à usiner (30).

18. Dispositif de positionnement suivant l'une des revendications 14 à 17, caractérisé en ce que le dispositif formant capteur (46) possède un premier ensemble comprenant au moins un premier et un second moyens de détection, qui sont disposés de manière à détecter les marques (50) d'adressage de coordonnées disposées selon des lignes parallèles à l'axe X, afin de délivrer une information de sortie déterminant des coordonnées de la position de la table de travail (24) dans le système de coordonnées, et qu'un second ensemble d'au moins un premier et un second moyens de détection sont disposés de manière à détecter les marques d'adresses de coordonnées disposés selon des lignes parallèles à l'autre axe (Y), afin de délivrer une information de sortie pour l'autre coordonnée de la position de la table de travail (24) dans le système de coordonnées.

19. Dispositif de positionnement selon la revendication 18, caractérisé en ce que les moyens de détection du premier ensemble sont décalés les uns par rapport aux autres le long d'un axe (X) afin de délivrer une information de sortie représentative de la position dans le système de coordonnées et de la direction de déplacement de la table de travail (24) le long d'un axe (X), et que les moyens de détection du second ensemble sont décalés les uns par rapport aux autres le long de l'autre axe (Y), afin de délivrer une information de sortie représentative de la position dans le système de coordonnées et de la direction de déplacement de la table de travail (24) le long de l'autre axe (Y).

20. Dispositif de positionnement selon la revendication 18 ou 19, caractérisé en ce que les moyens de détection comprennent chacune une fenêtre transparente (53) ainsi qu'un photodétecteur (55) coopérant avec cette fenêtre.

21. Dispositif de positionnement selon la revendication 20, caractérisé en ce que les fenêtres (53) comportent des groupes de zones rectangulaires allongées transparentes et parallèles, qui sont formées dans une plaque opaque (52), chaque zone possédant un axe longitudinal qui est perpendiculaire aux lignes ou aux colonnes, devant être détectées, de marques (59) d'adressage de coordonnées, la même largeur que celle des lignes ou des colonnes de marques d'adressage de coordonnées, une longueur égale à un multiple entier de la distance centre-à-centre, et possède un écart centre-à-centre, qui est égal à un multiple entier de l'écart centre-à-centre des lignes ou des colonnes correspondantes des marques (59) d'adressage de coordonnées.

22. Dispositif de positionnement selon l'une des revendications 18 à 21, caractérisé en ce qu'il est prévu des moyens de compensation, dont chacun comporte un couple de capteurs servant à compenser des variations indésirables de l'intensité de l'image.

23. Dispositif de positionnement selon la revendication 22, caractérisé en ce qu'un premier et un second photodétecteurs (55) de chaque couple de capteurs sont branchés en opposition.

24. Dispositif de positionnement selon l'une des revendications 18 à 23, caractérisé en ce que les couples de moyens de détection du premier ensemble de couples de moyens de détection sont décalés les uns par rapport aux autres le long d'un axe (X) de manière à délivrer une information de sortie représentative de la position dans le système de coordonnées et de la direction de déplacement de la table de travail (24) le long d'un axe (X), et que les couples de moyens de détection du second ensemble de couples de moyens de détection sont décalés les uns par rapport aux autres le long de l'axe (Y) afin de délivrer une information de sortie représentative de la position dans le système de coordonnées et de la direction de déplacement de la table de travail (24) le long de l'autre axe (Y).

25. Dispositif de positionnement selon l'une des revendications 19 ou 24, caractérisé en ce que les différents dispositifs de détection des différents ensembles de moyens de détection sont décalés les uns par rapport aux autres essentiellement d'un multiple impair de 90° le long de l'axe de coordonnées correspondant.

26. Dispositif de positionnement selon la revendication 25, caractérisé en ce que chaque couple de moyens de détection comporte une fenêtre transparente (53) d'un premier type, qui coopère avec un premier photodétecteur associé (55), et une fenêtre transparente (53) d'un second type, qui coopère avec un second photodétecteur associé (55) et possède une surface transparente qui est égale à celle de la fenêtre du premier type.

27. Dispositif de positionnement selon la revendication 26, caractérisé en ce que chaque fenêtre du premier type comporte une seule zone transparente ménagée dans la plaque opaque et comportant une ou plusieurs surfaces rectangulaires possédant une largeur et une longueur qui sont égales à un multiple entier de la distance centre-à-centre des lignes ou des colonnes correspondantes des marques d'adressage de coordonnées, et que chaque fenêtre du second type comporte un groupe de zones rectangulaires allongées transparentes et parallèles ménagées dans la plaque opaque, chaque zone comportant un axe longitudinal qui est perpendiculaire aux lignes ou aux colonnes correspondantes des marques d'adressage de coordonnées, devant être détectées, une largeur identique à la largeur correspondante des lignes ou à la largeur correspondante des colonnes de marques d'adressage de coordonnées et une longueur qui est égale à un multiple entier de la distance centre-à-centre des lignes ou des colonnes correspondantes des marques d'adressage de coordonnées.

28. Dispositif de positionnement selon l'une des revendications 18 à 27, caractérisé en ce qu'il est prévu des moyens de détection (114, 116; 115, 117) servant à détecter les marques (62) de référence de coordonnées de manière à produire une information de sortie en vue de son association aux marques détectées d'adressage de coordonnées.

29. Dispositif de positionnement selon la revendication 28, caractérisé en ce que le champ (45) d'adressage de coordonnées muni des marques (53) d'adressage de coordonnées possède un coefficient de réflexion et de transmission optique possédant une première valeur, que les marques (62) de référence de coordonnées possèdent respectivement un coefficient de réflexion ou de transmission optique possédant une seconde valeur et que les moyens de détection (114, 116; 115, 117), qui servent à détecter des marques de référence, possèdent un coefficient de réflexion ou de transmission optique se situant entre la première et la seconde valeurs.

30. Dispositif de positionnement selon la revendication 28 ou 29, caractérisé en ce que la table de travail (24) est amenée successivement dans une première position dans le système de coordonnées, dans laquelle une marque (62) de référence de coordonnées est détectée par les premiers moyens de détection (114, 116), tandis que les marques (59) d'adressage de coordonnées sont détectées par les moyens de détection (53, 55) prévus à cet effet, et dans une seconde position dans le système de coordonnées, dans laquelle les autres marques (62) de référence de coordonnées sont détectées par les seconds moyens de détection (115, 117), tandis que les marques (59) d'adressage de coordonnées sont détectées à l'aide des moyens de détection (53, 55) prévus à cet effet.

31. Dispositif de positionnement selon la revendication 30, caractérisé en ce que les moyens de détection servant à détecter les marques de référence (62) comprennent un couple de fenêtres transparentes (114, 115) du premier type, dont chacune coopère avec un photodétecteur associé (116, 117).

32. Dispositif de positionnement selon l'une des revendications 1 à 31, caractérisé en ce qu'il est prévu un dispositif optique (47 à 51) servant à projeter une image d'une partie du champ (45) des marques d'adressage de coordonnées sur le dispositif formant capteur (46), et que ce dispositif formant capteur (46) peut être actionné de manière à détecter les marques d'adressage de coordonnées dans l'image afin de délivrer une information de sortie qui est représentative de la position de la table de travail (24) dans le système de coordonnées.

33. Dispositif de positionnement selon la revendication 32, caractérisé en ce qu'une multiplicité de lentilles (54) sont prévues entre des fenêtres respectivement différentes (53) et des photodétecteurs associés (55) de manière à former l'image d'une lumière à l'aide des moyens optiques (47 à 51) indiqués en dernier lieu, par l'intermédiaire de la fenêtre correspondante, sur le photodétecteur associé (55), et ce avec une intensité qui est déterminée par les parties des marques (59) d'adressage de coordonnées, qui ont été détectées à travers la fenêtre correspondante (53).

**Claims**

1. An addressable positioner comprising stage means (24) movable along a pair of coordinate axes (X, Y) for holding an object, e.g. a workpiece; sensor means (46) for providing actual value output information representative of the actual coordinate position of the stage means; control means (65 to 94), including comparison means (71, 72), responsive to the actual value output information from the sensor means and input reference control information for moving the stage means to a desired coordinate position determined by the input reference control information, characterized in that a two dimensional position indicia array (45) consisting of coordinate addressing indicia (59) is affixed to the stage means (24), that optical means for projecting an image of at least part of the position indicia array (45) onto the sensor means is provided and that the sensor means (46) is designed for sensing the coordinate addressing indicia (59) in the image and for generating respective output information.

2. Positioner as in claim 1, characterized in that said control means (65—94) includes first control means (65—82), responsive to the output information from the sensor means (46) and to input control information determinative of desired coordinate positions of the stage means (24), and in that said sensor means (46) is also movable along a pair of coordinate axes, and said control means (65—94) further includes second control means (84—94) for moving the sensor means to effect movement of the stage means (24) to an interpolation of the desired coordinate position.

3. Positioner as in claim 2, characterized in that said positioner includes detector means (88, 89) for providing output information determinative of the coordinate position of the sensor means (46); and in that said second control means (84—94) is responsive to the output information from the detector means (88, 89) and to input control information determinative of a different interpolating coordinate position for moving the sensor means to said interpolating coordinate position to effect movement of the stage means to said interpolation of the desired coordinate position.

4. Positioner as in claim 2 or 3, characterized in that said first and second control means (65—82, 84—94) may be concurrently employed for moving the stage means (24) and the sensor means (46) to effect movement of the stage means to said interpolation of the desired coordinate position.

5. Positioner as in claim 4, characterized in that said stage means (24) may be coupled for movement with respect to the movement of the sensor means (46).

6. Positioner as in claim 5, characterized in that said first control means (65—82) includes switchable means ($S_x$, 81; $S_y$, 82) operable once the stage means is moved to within a preselected tolerance of the desired coordinate position for coupling the stage means to move with respect to movement of the sensor means.

7. Positioner as in claim 6, characterized in that said second control means (84—94) may be employed for moving the sensor means (46) to effect movement of the stage means (24) to said interpolation of the desired coordinate position.

8. Positioner as in one of claims 2 to 7, characterized in that said first control means (65—82) is operable for sequentially moving the stage means (24) to different desired coordinate positions to sequentially address different regions of the workpiece (30).

9. Positioner as in one of claims 4 to 8, characterized in that said second control means (84—94) includes variable input means (88, 89) for providing the input control information determinative of said interpolating coordinate position of the sensor means (46); comparative means (86, 87) responsive to the output information from the detector means and to the input control information from the variable input means for deriving an error signal; and servo drive means (84, 93; 85, 94) coupled to the sensor means and responsive to the error signal from the comparative means (86, 87) for moving the sensor means (46) to said interpolating coordinate position to effect movement of the stage means (24) to said interpolation of the desired coordinate position.

10. Positioner as in claim 9, characterized in that said detector means (88, 89) comprises a pair of linear variable differential transformers, each operable for providing output information determinative of a corresponding different coordinate of the actual coordinate position of the sensor means (46); in that said variable input means comprises a pair of potentiometers (91, 92) each operable for providing input control information determinative of a corresponding different coordinate of said interpolating coordinate position of the sensor means (46), said comparative means (86, 87) comprises a pair of comparator means, each responsive to the output information from a corresponding different one of the linear variable differential transformers (88, 89) and the input control information from a corresponding different one of the potentiometers (91, 92) for deriving an error signal; and in that said servo drive means (84, 93; 85, 94) includes a pair of servo motors (84, 85) each coupled to the sensor means (46) and each responsive to the error signal from a corresponding different one of the comparator means (86, 87) for moving the sensor means (46) along a corresponding different coordinate axis (X, Y) to a corresponding different coordinate of said interpolating coordinate position of the sensor means (46).

11. Positioner as in one of claims 4 to 10, characterized in that said first control means (65—82) includes control input means for providing the input control information determinative of the desired coordinate position of the stage means (24); said comparative means (71, 72) responsive to the output information from the sensor means (46) and to the input control information from the control input means (73) for deriving an error signal; and servo drive means (74, 76; 75, 77) coupled to the stage means (24) and responsive to the error signal from the last-mentioned comparative means (71, 72) for moving the stage means (24) to within a preselected tolerance of the desired coordinate position.

12. Positioner as in claim 11, characterized in that said first control means (65—82) further includes first amplifying means (65, 66) for receiving and amplifying the output information from the sensor means (46); and counting means (68, 69) responsive to the amplified output information from the first amplifying means (65, 66) for providing the last-mentioned comparative means (71, 72) with input position information indicative of the position of the stage means (24).

13. Positioner as in claim 12, characterized in that said switchable means ($S_x$, 81; $S_y$, 82) includes second amplifying means (81, 82) for receiving and amplifying a portion of the output information from the sensor means (46); said switchable means further includes switching means ($S_x$, $S_y$) operable once the stage means (24) is moved to within the preselected tolerance of the desired coordinate position, for switching said portion of the output information from the first amplifying means (65, 66) to the second amplifying means (81, 82); and said last-mentioned servo drive means (74, 76; 75, 77) is responsive to the amplified portion of the output information from the second amplifying means (81, 82) for moving the stage means (24) to the desired coordinate position.

14. Positioner as in any of the preceding claims, characterized in that said coordinate addressing indicia (59) are uniformly arrayed in rows parallel to one (X) of the first-mentioned coordinate axis and in columns parallel to the other (Y) of the first-mentioned coordinate axis.

15. Positioner as in claim 14, characterized in that said coordinate addressing indicia (59) are of uniform size, particularly square.

16. Positioner as in one of claims 14 or 15, characterized in that coordinate reference indicia (62) for the array (45) of coordinate addressing indicia are provided, said coordinate reference indicia (62) comprising portions of a border circumscribing the array (45) of coordinate addressing indicia (59).

17. Positioner as in one of claims 14 to 16, caracterized in that said indicia (59, 62) comprise reflective regions formed on a transparent plate disposed between the sensor means (46) and the workpiece (30).

18. Positioner as in one of claims 14 to 17, characterized in that said sensor means (46) includes a first set of at least a first and a second sensing means disposed for sensing the coordinate addressing indicia (59) arrayed in rows parallel to said one (X) of the first-mentioned coordinate axis to provide output information determinative of one coordinate of the coordinate position of the stage means (24); and a second set of at least a first and second sensing means disposed for sensing the coordinate addressing indicia arrayed in columns parallel to said other (Y) of the first-mentioned coordinate axis to provide output information determinative of another coordinate of the coordinate position of the stage means (24).

19. Positioner as in claim 18, characterized in that said sensing means of the first set of sensing means are offset from one another along said one (X) of the first-mentioned coordinate axis to provide output information determinative of the coordinate position and the direction of movement of the stage means along said one of the first-mentioned coordinate axis, and said sensing means of the second set of sensing means are offset from one another along said other (Y) of the first-mentioned coordinate axis to provide output information determinative of the coordinate position and the direction of movement of the stage means along said other (Y) of first-mentioned coordinate axis.

20. Positioner as in claim 18 or 19, characterized in that each of said sensing means comprises a transparent window (53) communicating with a corresponding photodetector (55).

21. Positioner as in claim 20, characterized in that each of said windows (53) comprises a group of parallel, transparent, elongated, rectangular regions formed in an opaque plate (52) with each region having an axis of elongation orthogonal to the rows or columns of addressing indicia (59) to be sensed thereby, having a width equal to that of each respective row or column of the respective addressing indicia, having a length equal to that of an integer multiple of the center-to-center spacing of the respective rows or columns of addressing indicia (59) and having a center-to-center spacing equal ·to that of an interger-multiple of the center-to-center-distance of each respective row or column of adressing indicia (59).

22. Positioner as in claims 18 to 21, characterized in that compensating means are provided, including each a pair of sensing means, for compensating for undesired variations in the intensity of the image.

23. Positioner as in claim 22, characterized in that said first and second photodetectors (55) of each pair of sensing means are connected in bucking relationship.

24. Positioner as in one of claims 18 to 23, characterized in that said first set of pairs of sensing means are offset from one another along said one (X) of the first-mentioned coordinate axis to provide output information determinative of the coordinate position and direction of movement of the stage means along said one (X) of the first-mentioned coordinate axis; and in that said second set of pairs of sensing means are offset from one another along said other (Y) of the first-mentioned coordinate axis to provide output information determinative of the coordinate position and direction of movement of the stage means (24) along said other (Y) of the first-mentioned coordinate axis.

25. Positioner as in one of claims 19 to 24, characterized in that said sensing means of each set of sensing means are offset from one another along the respective coordinate axis by substantially an odd integer multiple of 90°.

26. Positioner as in claim 25, characterized in that each of said pairs of sensing means comprises a transparent window (53) of a first kind communicating with a corresponding first photodetector (55) and a transparent window (53) of a second kind communicating with a corresponding second photodetector (55) and having a transparent area equal to that of the window of the first kind.

27. Positioner as in claim 26, characterized in that each of said windows of the first kind comprises a single transparent region formed in the opaque plate with one or more rectangular areas of a width and a length equal to an integer multiple of the center-to-center spacing of the respective rows or columns of addressing indicia and in that each of said windows of the second kind comprises a group of parallel, transparent, elongated, rectangular regions formed in an opaque plate with each region having an axis of elongation orthogonal to the respective rows or columns of addressing indicia to be sensed thereby, having a width equal to that of each respective row or column of addressing indicia to be sensed thereby, and having a length equal to that of an integer multiple of the center-to-center spacing of the respective rows or columns of addressing indicia.

28. Positioner as in one of claims 18 to 27, characterized in that reference indicia sensing means (114, 116; 115, 117) are provided for sensing the coordinate reference indicia (62) to provide output information for referencing the sensed coordinate addressing indicia.

29. Positioner as in claim 28, characterized in that said array (45) of coordinate addressing indicia (59) has an optical reflectance or transmission coefficient of a first value; each of said coordinate reference indicia (62) has an optical reflectance or transmission coefficient of a second value; and said reference indicia sensing means (114, 116; 115, 117) senses an optical reflectance or transmission coefficient intermediate the first and second values.

30. Positioner as in claim 28 or 29, characterized in that said stage means (24) may be sequentially moved to a first coordinate position at which one of the coordinate reference indicia (62) may be sensed by the first sensing means (114, 116) while coordinate addressing indicia (59) are sensed by the addressing indicia sensing means (53, 55) and to a second coordinate position at which the other of the coordinate reference indicia may be sensed by the second sensing means (115, 117) while the coordinate addressing indicia (59) are sensed by the addressing indicia sensing means (53, 55).

31. Positioner as in claim 30, characterized in that said reference indicia (62) sensing means comprises a pair of transparent windows (114, 115) of the first kind each communicating with a corresponding photodetector (116, 117).

32. Positioner as in any of the preceding claims, characterized in that said positioner includes optical means (47—51) for projecting an image of a portion of the array (45) of coordinate addressing indicia onto the sensor means (46); and in that said sensor means (46) is operable for sensing the coordinate addressing indicia in that image to provide the output information determinative of the coordinate position of the stage means.

33. Positioner as in claim 32, characterized in that a plurality of lenses (54) each disposed between a corresponding different one of the windows (53) and a corresponding different one of the photodetectors (55) is provided for imaging light from the last-mentioned optical means (47—51) through the corresponding window onto the corresponding photodetector (55) at an intensity determined by the portions of coordinate addressing indicia (59) detected by the corresponding window (53).

FIG    1

0 036 026

FIG 3

FIG 2

2

I   50   60   83

d⟶   X⟶

FIG   4

I   50'   60'   50'   60'   50'   60'

d⟶

20 μ

FIG   5

I   50   83

d⟶

10 μ

FIG   6

100%

Schwellwert 5/8 I

100%

I

25%

0   d⟶

FIG   7

118   119

116,117

120

FIG   8